# EUROPEAN PATENT SPECIFICATION

(11) **EP 3 420 118 B1**
(45) Date of publication and mention of the grant of the patent: **16.10.2019**
(21) Application number: 17715797.1
(22) Date of filing: 24.02.2017
(51) Int. Cl.: C23C 16/458, C30B 25/12, H01L 21/687

(54) **A SUBSTRATE CARRIER ASSEMBLY, A SUBSTRATE CARRIER AS WELL AS A SHIELDING SEGMENT FOR USE IN SUCH SUBSTRATE CARRIER ASSEMBLY**
SUBSTRATTRÄGERANORDNUNG, SUBSTRATTRÄGER SOWIE ABSCHIRMUNGSSEGMENT ZUR VERWENDUNG IN SOLCH EINER SUBSTRATTRÄGERANORDNUNG
ENSEMBLE SUPPORT DE SUBSTRAT, SUPPORT DE SUBSTRAT ET SEGMENT DE BLINDAGE DESTINÉ À ÊTRE UTILISÉ DANS LEDIT ENSEMBLE SUPPORT DE SUBSTRAT

(30) Priority: 25.02.2016 NL 2016318
(43) Date of publication of application: 02.01.2019
(73) Proprietor: Xycarb Ceramics B.V., 5705 CS Helmond (NL)
(72) Inventor: VULLINGS, Karel Johannes, 5705 CS Helmond (NL); BEEMSTER, Maarten Pieter Gilles, 5705 CS Helmond (NL)
(74) Representative: Algemeen Octrooi- en Merkenbureau B.V.
(86) International application number: PCT/NL2017/050111
(87) International publication number: WO 2017/146574

(56) References cited:
- DE-A1-102012 111 078
- US-A1- 2004 154 544

## Description

The invention relates to a substrate carrier assembly for use in a system for growing epitaxial layers on semiconductor substrates by chemical vapor deposition, said substrate carrier assembly comprising a substrate carrier having a first surface side, an area part of said first surface being provided with recessed pockets for accommodating - during use - said semiconductor substrates, as well as one or more shielding segments configured as removable-positioned plate shaped elements having a covering surface side for substantially covering the remaining area part of said first surface neighboring said pockets, as well as interlocking means for interlocking said one or more shielding segments with said substrate carrier.

Moreover the invention also relates to a substrate carrier as well as a shielding segment for use in such substrate carrier assembly.

A substrate carrier as defined above is implemented in chemical vapor deposition (CVD) processes for manufacturing semiconductor components. In a CVD process a stack of thin layers composed of materials such as gallium nitride are grown or deposited on a silicon, gallium nitride, or sapphire semiconductor substrate (also known as a wafer or wafer substrate), which semiconductor substrate is accommodated in a recessed pocket present in the deposition surface of the substrate carrier.

Such circular substrate carrier having multiple recessed pockets, each for accommodating a semiconductor substrate in a CVD process, is for example disclosed in DE 10 2012 111078, US2013/0276704A1 or in US-D695,242. In these citations the recessed pockets for the semiconductor substrates to be processed are evenly distributed across the first, deposition surface side of the substrate carrier. In another embodiment the recessed pockets are present in removable-positioned rotatable subcarrier elements that are distributed in a ring along the outer periphery, positioned on top of a circular primary carrier element. Such substrate carrier system is generally referred to as a 'planetary carrier' system.

In either known embodiment during the CVD process the overall deposition surface of the substrate carrier including the semiconductor substrates accommodated in the recessed pockets are subjected to the deposition gases leading to the deposition of semiconductor layers on the exposed surface sides of the semiconductor substrates, but also on the remaining exposed area part of the deposition surface side of the substrate carrier neighboring the pockets (and the substrates).

Whereas the former deposition ultimately leads to semiconductor end product deposited on the semiconductor substrates, the latter deposition is considered contaminating the substrate carrier, requiring period removal of such deposition. The action of removing such undesired deposition from the substrate carrier has a negative impact on the substrate carrier life span.

Hereto the known substrate carrier assembly may incorporate one or more removable-positioned shielding segments configured as thin or plate shaped elements for substantially covering said remaining area part of said deposition surface side of the substrate carrier neighboring said pockets. During the CVD process the one or more shielding segments are also subjected to the deposition of the semiconductor layers instead of said remaining area part of said first surface side of the substrate carrier, thus significantly avoiding and/or limiting contamination of the substrate carrier and hence increasing its lifespan.

As a substrate carrier with the semiconductor substrates accommodated in the recessed pockets is rotated during the CVD process the shielding segments can not be placed loosely onto the deposition surface side of the substrate carrier. Instead, separate interlocking means are used, generally formed by ceramic pins placed in holes present in both the top surface of the substrate carrier as in the bottom surface of the shielding segments, for keeping the shielding segments in place during the carrier rotation during the CVD process.

However the machining of holes in both the substrate carrier and shielding segments combined with pins of a different material having a different thermal characteristic compared to either or both the material of the substrate carrier and the shielding segment leads to material deformation, cracking and ultimately to a reduced lifespan of the substrate carrier. Additionally the elimination of the pins also eliminates the use of an extra material in the assembly, further reducing a potential source of chamber contamination, which otherwise will adversely affect the semiconductor deposition process.

The object of the invention is to provide a substrate carrier assembly according to the preamble, which is of inexpensive and simple construction and not exhibiting the drawbacks of the known substrate carrier assemblies.

Hereto said interlocking means consist of at least one pair of cooperating first and second interlocking elements, the first interlocking element forming a monolithic part with said substrate carrier and the second interlocking element forming a monolithic part with said one or more shielding segments.

As said interlocking means are an integral part of both said substrate carrier and said one or more shielding segments, separate parts are no longer required, which otherwise adversely affect the lifespan of the substrate carrier (in particular) and also adversely affect the semiconductor deposition process.

In particular the interlocking means are provided as cooperating alterations in both said remaining area part of said first surface side of the substrate carrier and the cover surface side of one or more shielding segments. This requires a local surface alteration in the contact surface sides of both the substrate carrier and the shielding segments, without significantly altering the mechanical and material properties of both assembly parts, in particular that of the substrate carrier.

In an embodiment said cooperating interlocking means are configured as at least one dent and at least one bulge. Dents and bulges can be easily machined into the surface sides of both the substrate carrier and the shielding segments without creating lifespan limiting stress point or lines in the material.

In particular the at least one dent and the at least one bulge might, in one embodiment, exhibit a circular configuration, whereas in another embodiment the at least one dent and the at least one bulge exhibit could have an elliptical configuration. It needs to be emphasized that the matching bulge and dent shapes are not limited to the shapes in before mentioned embodiments. The bulge-dent configurations exhibit a self-aligning ability when placing the shielding segments on the substrate carrier, whilst maintaining a steady positioning of the shielding segments on the substrate carrier whilst rotating during the semiconductor deposition process.

An improved self-alignment and steady positioning is obtained when the at least one dent and the at least one bulge exhibit a torus configuration. Herewith a dual rim is present for retaining the position of the shielding elements on the substrate carrier.

In an example embodiment at least part of the outer dimensions of the at least one bulge are oversized compared to the corresponding part of the inner dimensions of the cooperating dent. the maximum height of the at least one bulge is larger than the maximum depth of the cooperating dent. By choosing oversized dimensions of the at least one bulge compared to the inner dimensions of the cooperating dent, a small pre-determined fissure or gap remains present between the upper face of the substrate carrier and the lower face of the shielding element, when during use the oversized bulge comes to rest in the cooperating dent. This allows a gap-controlled transport of cooling gas for establishing optimal temperature conditions across the surface of the substrate carrier. It should be noted that the bulge/dent configuration responsible for the gap height definition, could differ between the elements on one and the same cover segment.

For creating such small, pre-determined fissure or gap between the upper face of the substrate carrier and the lower face of the shielding element at least part of the outer dimensions of the at least one bulge can be dimensioned such, that the maximum height of the at least one bulge is larger than the maximum depth of the cooperating dent.

Such small, pre-determined fissure or gap is likewise created in other configuration wherein the maximum diameter of the at least one bulge is larger than the maximum inner diameter of the cooperating dent, or wherein, with respect to the plane of the substrate carrier, the slope of the at least one bulge is larger than the inner slope of the cooperating dent.

In an embodiment where such small, pre-determined fissure or gap is not required or even desired due to specific conditions dictated for the chemical vapor deposition (CVD) process being implemented at least part of the inner dimensions of the at least one dent are oversized compared to the corresponding part of the outer dimensions of the cooperating bulge. Here no small, pre-determined fissure or gap is being created, and the lower face of the shielding element rests on (or abuts against) the upper face of the substrate carrier.

This effect (no fissure or gap being present) is effectuated when the maximum depth of the at least one bulge is larger than the maximum height of the cooperating dent, or when the maximum diameter of the at least one bulge is smaller than the maximum inner diameter of the cooperating dent, or when, with respect to the plane of the substrate carrier, the slope of the at least one bulge is smaller than the inner slope of the cooperating dent.

The invention will now be explained in more detail with reference to a drawing, in which:
Figure 1a shows a known embodiment of a substrate carrier;
Figure 1b shows another known embodiment of a substrate carrier;
Figure 2a shows a known embodiment of a shielding element positioned on a substrate carrier;
Figure 2b shows another known embodiment of a shielding element positioned on a substrate carrier;
Figures 3-5 show enlarged views of interlocking means in a substrate carrier assembly according to the invention;
Figure 6 shows a configuration of the interlocking means in a substrate carrier assembly according to the invention;
Figure 7 shows another configuration of the interlocking means in a substrate carrier assembly according to the invention;
Figure 8 shows yet another configuration of the interlocking means in a substrate carrier assembly according to the invention.

For a clear understanding of the detailed description below identical parts depicted in the accompanying drawings are denoted with like reference numerals.

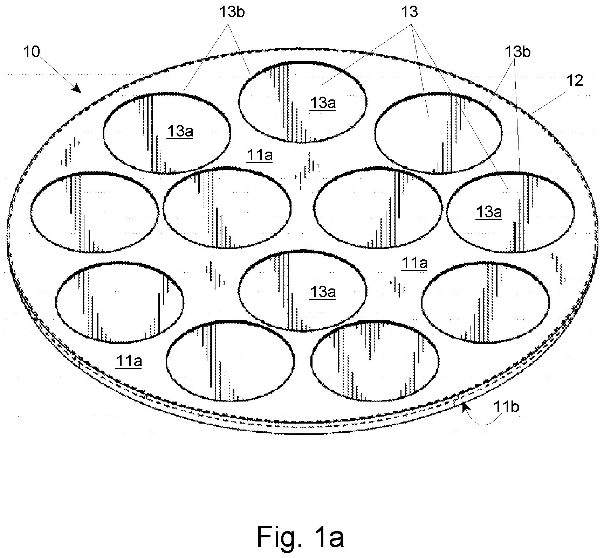

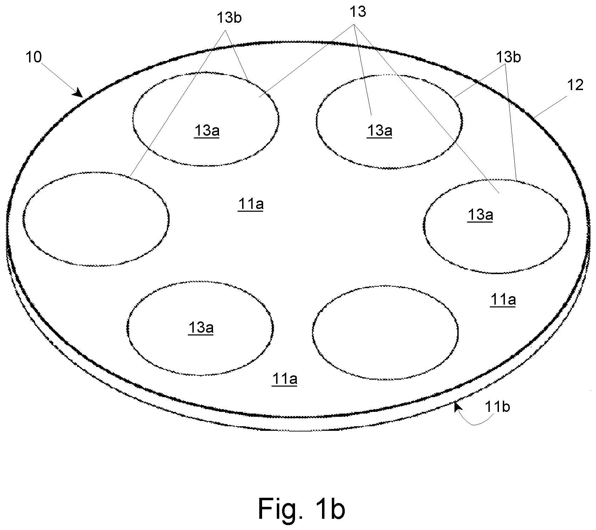

Figure 1 discloses a known embodiment of substrate carrier according to the state of the art as for example disclosed in US-D695,242. The substrate carrier is denoted with reference numeral 10 and has a disk-shaped configuration, in particular made from graphite. The disk-shaped substrate carrier 10 has a first, upper surface side 11a and a second, lower surface side 11b, which is opposite from the first, upper surface side 11a. As disclosed in Figure 1a the disk-shaped substrate carrier 10 has a circular outer periphery edge 12.

The substrate carrier 10 is provided with multiple pockets 13, which in this embodiment are evenly distributed across the first surface side 11a. The pockets 13 are recessed in the material of the disk-shaped substrate carrier 10 and each pocket 13 is bound by a flat circular pocket surface side 13a and a steep edge 13b.

Each recessed pocket 13 serves for accommodating during use in a chemical vapor deposition (CVD) process a semiconductor substrate (not depicted) on which semiconductor substrates semiconductor layers are deposited for manufacturing semiconductor components such as LEDs. Thus with a multi-pocket substrate carrier a batch of several semiconductor substrates can be processed simultaneously in a CVD process.

Whereas in Figure 1a the recessed pockets 13 are evenly distributed across the deposition surface side 11a of the substrate carrier 10, another embodiment is shown in Figure 1b. In the embodiment of Figure 1b the recessed pockets 13 are only distributed in a ring or circle along the outer periphery edge 12 of the circular substrate carrier 10. The embodiment of Figure 1b is in general indicated as a "planetary carrier".

When implementing both embodiments of the substrate carrier of Figure 1a and Figure 1b in a CVD process batch the complete deposition surface side 11a of the substrate carrier 10 including the (non-depicted) semiconductor substrates accommodated in the recessed pockets 13 are subjected to the deposition gases leading to the deposition of semiconductor layers on both the semiconductor substrates as well as the remaining exposed area part of the first, upper deposition surface 11a of the substrate carrier 10 neighboring the pockets 13. As indicated in the introductory part of this patent application the latter deposition is undesired, as it unnecessary contaminates the substrate carrier 10 for subsequent CVD process batches, and thus limits its lifespan.

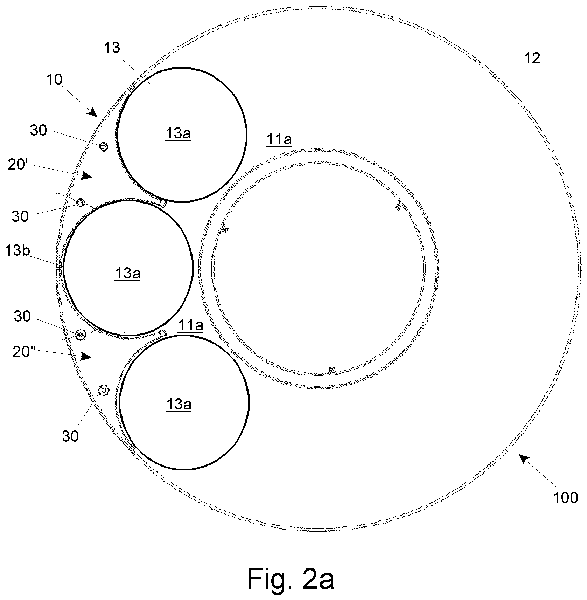

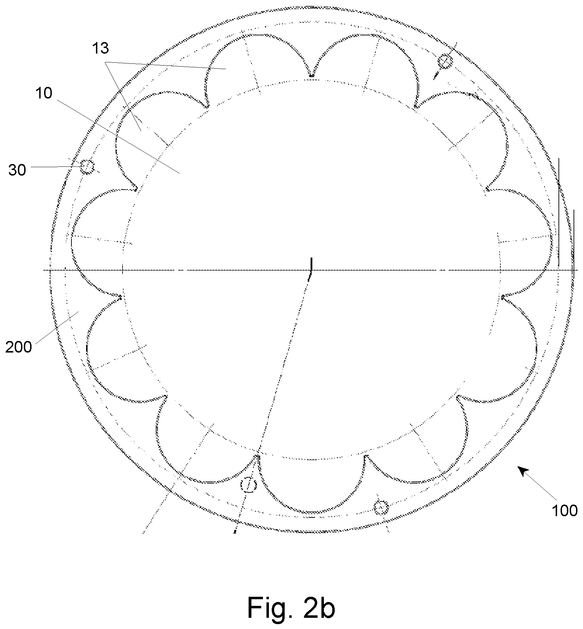

Hereto as depicted in Figures 2a and 2b the known substrate carrier assembly 100 also incorporates one or more shielding elements 20'-20"-etc-etc and 200. These shielding segments are configured as thin or plate shaped elements, which could be made from materials like, but not limited to graphite, or quartz, that substantially cover the remaining area part of the first, upper deposition surface side 11a of the substrate carrier 10 neighboring the pockets 13. In Figure 2a multiple shielding segments 20'-20"-etc-etc are used to substantially cover or shield the remaining area part of the first, upper deposition surface side 11a, whereas in Figure 2b an embodiment is disclosed wherein one shielding segment 200 more or less equalizes the multiple shielding segments 20'-20"-etc-etc of Figure 2a to substantially covering or shielding the remaining area part.

Hence, during the CVD process, the recessed pockets 13 are occupied by semiconductor substrates (not shown in the Figures 2a and 2b) whereas several shielding segments 20'-20"-etc-etc are substantially (or nearly completely) covering the remaining part of the first, upper deposition surface side 11a such that the majority (nearly all) of the exposed surface side 11a is shielded from the deposition gases during the CVD process. Herewith the semiconductor layers are deposited on the shielding segments instead of on the remaining area part of the first, upper surface side 11a.

The shielding segments 20'-20"-etc-etc (of Figure 2a) and 200 (of Figure 2b) are lower cost parts and can be readily replaced and discarded, unlike the more expensive substrate carrier 10, which is to be used in larger number of CVD process runs. Hence herewith, the latter lifespan is increased significantly.

As the substrate carrier 10 is being rotated during the CVD process it is required that the several shielding segments 20'-20"-etc-etc maintain their position onto the first, upper deposition surface side 11a of the substrate carrier 10. Hereto the known substrate carrier assembly 100 incorporate separate interlocking means, consisting of ceramic or metallic pins, which are provided in corresponding holes applied in both the deposition (first) surface side 11a of the substrate carrier 10 as well as the covering contact surface side 21a of each shielding segment 20'-20"-etc-etc (and 200).

The use of such pins, manufactured from a different material having a different thermal characteristic compared to the (graphite) material of the substrate carrier (and the shielding segments) lead to local material deformation and cracking and ultimately to a reduced lifespan of the substrate carrier 10, as well as increased cost due to the need for a third component required to fix the shielding elements into their position.

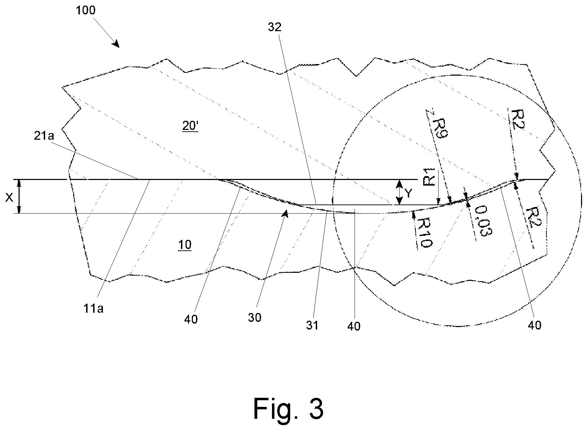

In Figures 3-4-5 embodiments are disclosed of an improved interlocking mechanism between a substrate carrier 10 and the cooperating shielding segments 20'-20"-etc-etc (or 200) according to the invention.

In particular the interlocking means are denoted in Figures 3-4-5 with reference numeral 30 respectively and are an integral part of both the substrate carrier 10 and the several shielding segments 20'-20"-etc-etc (or 200).

As depicted in Figure 3 the interlocking means 30 are provided as cooperating alterations 31-32 in both the first, upper deposition surface side 11a and the covering lower contact surface side 21a of the substrate carrier 10 and the shielding segments 20'-20"-etc-etc (or 200). As shown in Figure 3 the cooperating interlocking means 30 are configured as at least one dent 31 which is provided in the remaining part of the first, upper surface side 11a of the substrate carrier 10 and a cooperating bulge 32 which is provided in the covering lower contact surface side 21a of the shielding segments 20'-20"-etc-etc (or 200).

Providing dents 31 and bulges 32 in the respective surface sides of the two parts of a substrate carrier assembly 100 is an inexpensive solution as both the dents 31 and the bulges 32 can be machined into the material (mostly graphite material) of which the substrate carrier 10 and the shielding segments 20'-20"-etc-etc (or 200) are manufactured.

In particular, the dents 31 and the bulges 32 exhibit a smooth surface transition without discrete transitions (as is the case with drilled holes in the prior art interlocking means) in the lattice structure of the graphite material. As such material stress points or stress lines in the lattice structure are avoided, which otherwise - as in the prior art - will result in material deformation and cracking due to the thermal influences (heating and cooling) during the subsequent CVD process batches.

Instead the smooth surface transition of the dents 31 and the bulges 32 allow for a loose yet steady positioning of the shielding segments onto the substrate carrier 10 thereby avoiding contamination of the remaining area part of the surface side 11a of the substrate carrier 10 due to the deposition gasses.

In particular the application of dents 31 and bulges 32 having a smooth surface transition requires solely a local surface alteration of the contact surface sides without significantly altering the mechanical and material properties of both assembly parts, in particular that of the substrate carrier 10.

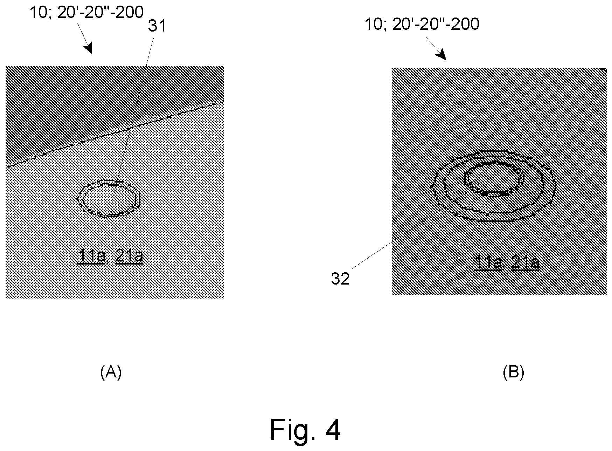

As shown in Figure 4 both the dent 31 and the bulge 32 can be applied to either the substrate carrier 10 or the several shielding segments 20'-20"-etc-etc (or 200) cooperating with said substrate carrier 10. In one embodiment as disclosed in Figure 3 the substrate carrier 10 is provided with multiple dents 31 applied in the remaining area part of the first, upper deposition surface side 11a neighboring the several recessed pockets 13 (see Figure 2a and 2b) whereas the cooperating bulges 32 are applied in the covering lower contact surface side 21a of the respective shielding segments 20'-20"-etc-etc (or 200).

In another embodiment (not shown) it will be clear that the bulges 32 can be present in the remaining area part of the first, upper deposition surface side 11a of the substrate carrier 10 and the cooperating dents 31 being present in the covering lower contact surface sides 21a of the respective shielding segments 20'-20"-etc-etc (or 200).

In yet another embodiment (not shown) both the substrate carrier 10 as well as the cooperating shielding segments 20'-20"-etc-etc (or 200) can be provided with both dents 31 and bulges 32.

As disclosed in Figure 4 both the dents 31 and the bulges 32 have a circular shape, whereas in another embodiment (not shown) the dents 31 and the bulges 32 exhibit an elliptical configuration. Both circular and elliptical configuration of the dents 31 and the bulges 32 exhibit a self-aligning ability, when placing the shielding segments 20'-20"-etc-etc (or 200) on the substrate carrier 10. Both circular as elliptical configurations guarantee a steady positioning of the shielding segments 20'-20"-etc-etc (or 200) on the substrate carrier 10, whilst rotating the latter during the semiconductor deposition process (CVD).

As clearly disclosed in Figure 3, the outer dimensions of the bulge 32 and in particular the maximum height Y of the bulge 32 is smaller than the maximum depth X (inner dimensions) of the corresponding mating dent 31. The bulge 32 is completely accommodated inside the dent 31, only creating a small fissure or gap 40 remains present between the dent 32 and the bulge 31. The first, upper side 11a of the substrate carrier 10 and the covering lower contact surface 21a of the cooperating shielding segment 20'-20"-etc-etc (or 200) are brought in an abutting contact with each other.

Likewise, the peripheral dimensions of the bulge 32 in particular the applied radii (or outer dimensions) of the bulge shape are different from the inner radii (or inner dimensions) of the dent 31. In other words the outer shape (outer dimensions) of the bulge 32 is preferably not identical to the inner shape (inner dimensions) of the dent 31 such that the outer shape or contour of the bulge 32 does not completely follow (or align) the inner shape or contour of the dent 31. Due to the non-complementary or non-congruent shape of both the dents 31 and the bulges 32 a fissure or gap 40 is maintained when the shielding segment 20'-20"-etc-etc (or 200) is being placed on the substrate carrier 10.

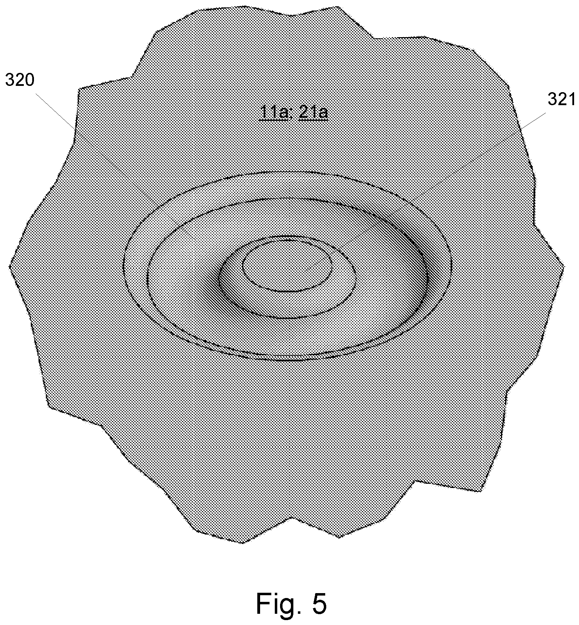

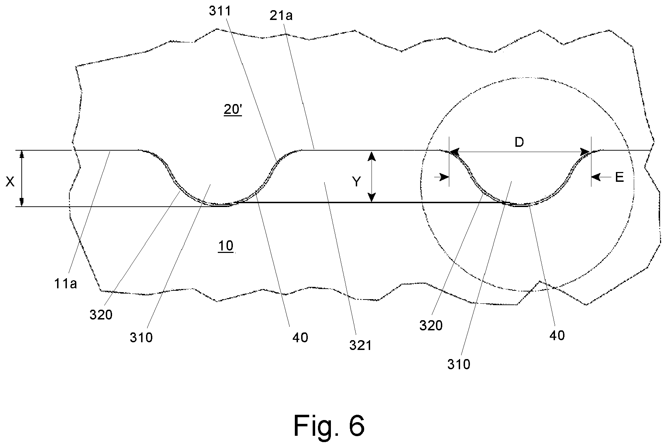

In another embodiment as shown in Figures 5 the bulge and the dent of the interlocking means 30 exhibit a torus configuration. In Figure 5 the dent 320 is disclosed in either the surface side 11a of the substrate carrier 10 or the surface side 21a of the shielding segments 20'-20"-etc-etc (or 200) having an inner torus bulge 321 positioned within the dent 320. The cooperating mating torus shaped bulge 310 (see Figure 6) is being provided in the middle of said bulge 310 with an inner torus dent 311 for accommodating the inner torus bulge 321 of the torus shaped dent 320.

In this embodiment as shown Figure 6 the configurations of the bulge and the cooperating dent are such, that at least part of the inner dimensions (inner contour or shape) of the dent 320 are oversized compared to (the corresponding parts of) the outer dimensions of the bulge 310. Due to the oversized dimensions of the dent 320 the maximum height Y of the torus shaped bulge 310 is smaller than the maximum height (or depth) X of the torus shaped dent 320, thus creating a fissure or gap 40 between both the bulge and the dent resulting in a full abutment of the lower contacting surface 21a of the cooperating shielding element 20'-20"-etc-etc (or 200) with (against) the first, upper surface 11a of the substrate carrier 10.

This allows for a proper and stable contact between both the substrate carrier 10 and the cooperating shielding element 20'-20"-etc-etc (or 200) during the chemical vapor deposition (CVD) processes, which are conducted whilst the substrate carrier and the shielding element assembly is being rotated.

Such full abutment of the lower contacting surface 21a of the cooperating shielding element 20'-20"-etc-etc (or 200) with (against) the first, upper surface 11a of the substrate carrier 10 can also be obtained by configuring the oversized inner dimensions of the dent 320 (compared to the outer dimensions of the bulge 310) such that a maximum diameter D of the bulge 310 is smaller than the maximum inner diameter E of the dent 320. As such (the outer surface of) the bulge 310 falls entirely within the space formed by (the inner dimensions) of the dent 320 resulting in a full abutment of the lower contacting surface 21a of the cooperating shielding element 20'-20"-etc-etc (or 200) with (against) the first, upper surface 11a of the substrate carrier 10 and no fissure or gap 41 is created and a fissure 41 is absent.

The absence of a fissure of gap 41 between the cooperating shielding element 20'-20"-etc-etc (or 200) and the substrate carrier 10 can also created by configuring the slope of the bulge 310 (with respect to the horizontal plane formed by the first, upper surface side 11a of the substrate carrier 10) such that the slope of the bulge steeper than the slope of the dent and the bulge 310 is completely accommodated in (the space or hole formed by) the dent.

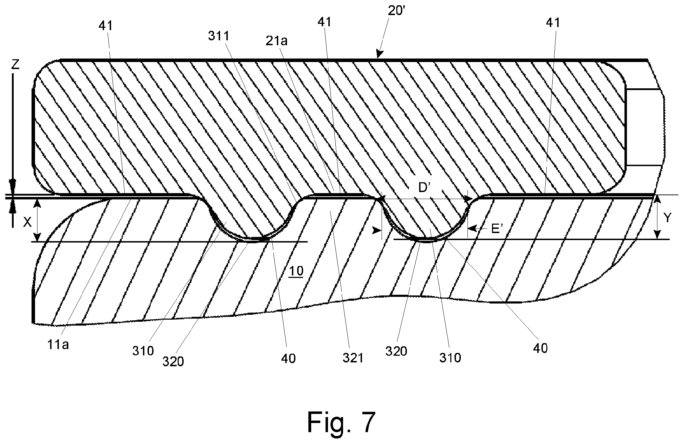

In the embodiment as shown Figure 7 the configurations of the bulge and the cooperating dent are such, that at least part of the inner dimensions (inner contour or shape) of the dent 320 are undersized compared to (the corresponding parts of) the outer dimensions of the bulge 310. Or in other words, at least part of the outer dimensions (outer contour or shape) of the bulge 310 are oversized compared to (the corresponding parts of) the inner dimensions of the dent 320.

Due to the oversized dimensions of the bulge 310 the maximum height Y of the torus shaped bulge 310 is larger than the maximum height (or depth) X of the torus shaped dent 320, thus creating a fissure or gap 40 between both the bulge and the dent, as well as a fissure or gap 41 between the first, upper surface 11a of the substrate carrier 10 and the lower contacting surface 21a of the cooperating shielding element 20'-20"-etc-etc (or 200). Through said fissure or gap 40 and 41 a cooling gas can be guided (via non-depicted gas feed through channels provided through the substrate carrier 10 from the lower surface side 11b towards the upper surface side 11a) for establishing an optimal desired temperature gradient across the substrate carrier 10, in particular across the first, upper surface side 11a on which the several semiconductor substrates are positioned in the pockets 13.

Such fissure or gap 40 and 41 can also be obtained by configuring the oversized dimensions of the bulge 310 (compared to the inner dimensions of the dent 320) such that a maximum diameter D of the bulge 310 is larger than the maximum inner diameter E of the dent 320. As such the outer surface of the bulge 310 rests on the inner wall of the dent 320 on a contact surface ring and in a similar fashion as with the differences in heights X and Y the cooperating shielding element 20'-20"-etc-etc (or 200) is raised from the substrate carrier 10, thus forming a fissure or gap 40 and 41 across the whole surface area of the substrate carrier 10.

Such fissure of gap 40 and 41 can also created by configuring the slope of the bulge 310 (with respect to the horizontal plane formed by the first, upper surface side 11a of the substrate carrier 10) in a different manner (that is smaller) compared to the corresponding slope of the dent 320. By configuring the slope of the bulge less steep than the slope of the dent the bulge can only be accommodated in the dent to a smaller extent, such that the cooperating shielding element 20'-20"-etc-etc (or 200) is raised from the substrate carrier 10, thus forming a fissure or gap 40 and 41 across the whole surface area of the substrate carrier 10.

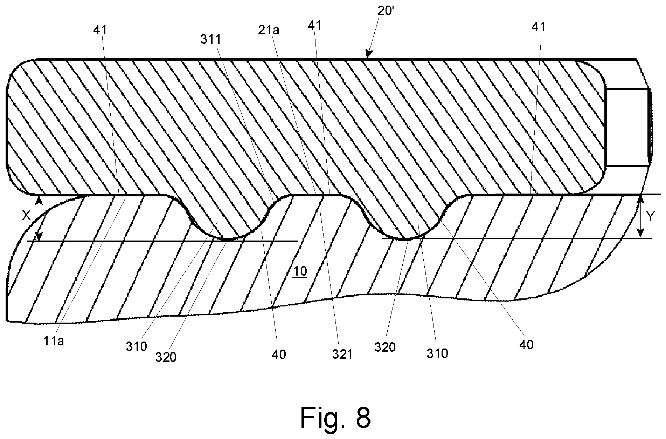

In the embodiment as shown Figure 8 the configurations of the bulge and the cooperating dent are such, that the inner dimensions (inner contour or shape) of the dent 320 are identical to (the corresponding parts of) the outer dimensions of the bulge 310. Due to this also a full abutment of the first, upper surface 11a of the substrate carrier 10 and the lower contacting surface 21a of the cooperating shielding element 20'-20"-etc-etc (or 200) is obtained.

It is obvious for those having ordinary skills in the art that other materials than (SiC-coated) graphite could be used as material for the shielding elements. Another material commonly used for shielding elements, covering a SiC-coated graphite substrate carrier in MOCVD process tools is quartz. It should be noted that the presented embodiments are not limiting the scope of the invention. The presented invention can be practiced on all combinations of substrate carrier and shielding element material combinations.

## Claims

1. A substrate carrier assembly (100) for use in a system for growing epitaxial layers on semiconductor substrates by chemical vapor deposition, said substrate carrier assembly comprising:
a substrate carrier (10) having a first surface side (11a) an area part of said first surface being provided with recessed pockets (13) for accommodating - during use - said semiconductor substrates, as well as
one or more shielding segments (20', 20") configured as removable-positioned plate shaped elements having a covering surface side for covering the remaining area part of said first surface neighboring said pockets, as well as
interlocking means (30) for interlocking said one or more shielding segments with said substrate carrier, **characterized in that** said interlocking means consist of at least one pair of cooperating first (31) and second (32) interlocking elements, the first interlocking element forming a monolithic part with said substrate carrier and the second interlocking element forming a monolithic part with said one or more shielding segments.

2. The substrate carrier assembly of claim 1, wherein said pair of cooperating first and second interlocking elements are provided as cooperating alterations in both said remaining area part of said first surface side of the substrate carrier and the cover surface side of said one or more shielding segments.

3. The substrate carrier assembly of claim 1 or 2, wherein said cooperating first and second interlocking elements are configured as at least one dent and at least one bulge.

4. The substrate carrier assembly of claim 3, wherein the at least one dent and the at least one bulge exhibit a circular configuration or wherein the at least one dent and the at least one bulge exhibit an elliptical configuration.

5. The substrate carrier assembly of any one of the claims 3 to 4, wherein the at least one dent and the at least one bulge exhibit a torus configuration.

6. The substrate carrier assembly of any one of the claims 3 to 5, wherein at least part of the outer dimensions of the at least one bulge are oversized compared to the corresponding part of the inner dimensions of the cooperating dent.

7. The substrate carrier assembly of claim 6, wherein the maximum height of the at least one bulge is larger than the maximum depth of the cooperating dent.

8. The substrate carrier assembly of claim 6 or 7, wherein the maximum diameter of the at least one bulge is larger than the maximum inner diameter of the cooperating dent.

9. The substrate carrier assembly of anyone of the claims 6 to 8, wherein, with respect to the plane of the substrate carrier, the slope of the at least one bulge is larger than the inner slope of the cooperating dent.

10. The substrate carrier assembly of any one of the claims 3 to 5, wherein at least part of the inner dimensions of the at least one dent are oversized compared to the corresponding part of the outer dimensions of the cooperating bulge.

11. The substrate carrier assembly of claim 10, wherein the maximum depth of the at least one dent is larger than the maximum height of the cooperating bulge.

12. The substrate carrier assembly of claim 10 or 11, wherein the maximum inner diameter of the at least one dent is greater than the maximum diameter of the cooperating bulge.

13. The substrate carrier assembly of anyone of the claims 10 to 12, wherein, with respect to the plane of the substrate carrier, the slope of the at least one bulge is smaller than the inner slope of the cooperating dent.

14. A substrate carrier, being part of a substrate carrier assembly for use in a system for growing epitaxial layers on semiconductor substrates by chemical vapor deposition, said substrate carrier having a first surface, an area part of said first surface side being provided with recessed pockets for accommodating - during use - said semiconductor substrates, as well as interlocking means as defined in one or more of the claims 1 to 13.

15. A shielding segment (20', 20"), being part of a substrate carrier assembly for use in a system for growing epitaxial layers on semiconductor substrates by chemical vapor deposition, said shielding segment being configured as a plate shaped element, as well as interlocking means as defined in one or more of the claims 1 to 13.

## Patentansprüche

1. Substratträgerbaugruppe (100) zur Verwendung in einem System zum Wachsenlassen epitaktischer Schichten auf Halbleitersubstraten durch chemische Aufdampfung, wobei die Substratträgerbaugruppe Folgendes umfasst:
einen Substratträger (10) mit einer ersten Oberflächenseite (11a), wobei ein Bereich der ersten Oberfläche mit ausgesparten Taschen (13) zum Aufnehmen, beim Gebrauch, der Halbleitersubstrate versehen ist, sowie
ein oder mehrere Abschirmungssegmente (20', 20"), konfiguriert als entfernbar positionierte plattenförmige Elemente mit einer abdeckenden Oberflächenseite zum Abdecken des verbleibenden Bereichs der den Taschen benachbarten ersten Oberfläche, sowie
Verriegelungsmittel (30) zum Verriegeln der ein oder mehreren Abschirmungssegmente mit dem Substratträger, **dadurch gekennzeichnet, dass** das Verriegelungsmittel aus wenigstens einem Paar zusammenwirkender erster (31) und zweiter (32) Verriegelungselemente besteht, wobei das erste Verriegelungselement einen monolithischen Teil mit dem Substratträger bildet und das zweite Verriegelungselement einen monolithischen Teil mit den ein oder mehreren Abschirmungssegmenten bildet.

2. Substratträgerbaugruppe nach Anspruch 1, wobei das Paar zusammenwirkender erster und zweiter Verriegelungselemente als zusammenwirkende Veränderungen sowohl im verbleibenden Bereich der ersten Oberflächenseite des Substratträgers als auch in der abdeckenden Oberflächenseite der ein oder mehreren Abschirmungssegmente vorgesehen sind.

3. Substratträgerbaugruppe nach Anspruch 1 oder 2, wobei die zusammenwirkenden ersten und zweiten Verriegelungselemente als wenigstens eine Vertiefung und wenigstens eine Ausbauchung konfiguriert sind.

4. Substratträgerbaugruppe nach Anspruch 3, wobei die wenigstens eine Vertiefung und die wenigstens eine Ausbauchung eine kreisförmige Konfiguration haben oder wobei die wenigstens eine Vertiefung und die wenigstens eine Ausbauchung eine elliptische Konfiguration haben.

5. Substratträgerbaugruppe nach einem der Ansprüche 3 bis 4, wobei die wenigstens eine Vertiefung und die wenigstens eine Ausbauchung eine Toruskonfiguration haben.

6. Substratträgerbaugruppe nach einem der Ansprüche 3 bis 5, wobei wenigstens ein Teil der Außenabmessungen der wenigstens einen Ausbauchung im Vergleich zum entsprechenden Teil der Innenabmessungen der zusammenwirkenden Vertiefung überbemessen ist.

7. Substratträgerbaugruppe nach Anspruch 6, wobei die maximale Höhe der wenigstens einen Ausbauchung größer ist als die maximale Tiefe der zusammenwirkenden Vertiefung.

8. Substratträgerbaugruppe nach Anspruch 6 oder 7, wobei der maximale Durchmesser der wenigstens einen Ausbauchung größer ist als der maximale Innendurchmesser der zusammenwirkenden Vertiefung.

9. Substratträgerbaugruppe nach einem der Ansprüche 6 bis 8, wobei mit Bezug auf die Ebene des Substratträgers das Gefälle der wenigstens einen Ausbauchung größer ist als das Innengefälle der zusammenwirkenden Vertiefung.

10. Substratträgerbaugruppe nach einem der Ansprüche 3 bis 5, wobei wenigstens ein Teil der Innenabmessungen der wenigstens einen Vertiefung im Vergleich zum entsprechenden Teil der Außenabmessungen der zusammenwirkenden Ausbauchung überbemessen ist.

11. Substratträgerbaugruppe nach Anspruch 10, wobei die maximale Tiefe der wenigstens einen Vertiefung größer ist als die maximale Höhe der zusammenwirkenden Ausbauchung.

12. Substratträgerbaugruppe nach Anspruch 10 oder 11, wobei der maximale Innendurchmesser der wenigstens einen Vertiefung größer ist als der maximale Durchmesser der zusammenwirkenden Ausbauchung.

13. Substratträgerbaugruppe nach einem der Ansprüche 10 bis 12, wobei mit Bezug auf die Ebene des Substratträgers das Gefälle der wenigstens einen Ausbauchung kleiner ist als das Innengefälle der zusammenwirkenden Vertiefung.

14. Substratträger, der Teil einer Substratträgerbaugruppe zur Verwendung in einem System zum Wachsenlassen epitaktischer Schichten auf Halbleitersubstraten durch chemische Aufdampfung ist, wobei der Substratträger eine erste Oberfläche hat, wobei ein Bereich der ersten Oberflächenseite mit ausgesparten Taschen zum Aufnehmen, beim Gebrauch, der Halbleitersubstrate sowie mit Verriegelungsmitteln wie in einem oder mehreren der Ansprüche 1 bis 13 definiert versehen ist.

15. Abschirmungssegment (20', 20"), das Teil einer Substratträgerbaugruppe zur Verwendung in einem System zum Wachsenlassen epitaktischer Schichten auf Halbleitersubstraten durch chemische Aufdampfung ist, wobei das Abschirmungssegment als plattenförmiges Element sowie als Verriegelungsmittel wie in einem der Ansprüche 1 bis 13 definiert konfiguriert ist.

## Revendications

1. Ensemble support de substrat (100) destiné à être utilisé dans un système pour la croissance de couches épitaxiales sur des substrats semi-conducteurs par dépôt chimique en phase vapeur, ledit ensemble support de substrat comprenant :
un support de substrat (10) ayant un premier côté de surface (11a), une partie de zone de ladite première surface étant munie de poches en retrait (13) pour loger - en cours d'utilisation - lesdits substrats semi-conducteurs, ainsi que
un ou plusieurs segment(s) de protection (20', 20") configuré(s) en tant qu'éléments en forme de plaque positionnés de manière amovible ayant un côté de surface de couverture pour recouvrir la partie de zone restante de ladite première surface voisine desdites poches, ainsi que
des moyens de verrouillage (30) pour verrouiller ledit ou lesdits plusieurs segment(s) de protection avec ledit support de substrat, **caractérisé en ce que** lesdits moyens de verrouillage sont constitués d'au moins une paire de premier (31) et deuxième (32) éléments de verrouillage coopérant, le premier élément de verrouillage formant une partie monolithique avec ledit support de substrat et le deuxième élément de verrouillage formant une partie monolithique avec ledit ou lesdits plusieurs segment(s) de protection.

2. Ensemble support de substrat de la revendication 1, dans lequel ladite paire de premier et deuxième éléments de verrouillage coopérants sont prévus en tant qu'altérations coopérantes dans à la fois ladite partie de zone restante dudit premier côté de surface du support de substrat et le côté de surface de couverture dudit ou desdits plusieurs segment(s) de protection.

3. Ensemble support de substrat de la revendication 1 ou 2, dans lequel lesdits premier et deuxième éléments de verrouillage coopérants sont configurés sous la forme d'au moins un enfoncement et d'au moins un renflement.

4. Ensemble support de substrat de la revendication 3, dans lequel l'au moins un enfoncement et l'au moins un renflement présentent une configuration circulaire ou dans lequel l'au moins un enfoncement et l'au moins un renflement présentent une configuration elliptique.

5. Ensemble support de substrat de l'une quelconque des revendications 3 et 4, dans lequel l'au moins un enfoncement et l'au moins un renflement présentent une configuration torique.

6. Ensemble support de substrat de l'une quelconque des revendications 3 à 5, dans lequel au moins une partie des dimensions extérieures de l'au moins un renflement est surdimensionnée par rapport à la partie correspondante des dimensions intérieures de l'enfoncement coopérant.

7. Ensemble support de substrat de la revendication 6, dans lequel la hauteur maximale de l'au moins un renflement est plus grande que la profondeur maximale de l'enfoncement coopérant.

8. Ensemble support de substrat de la revendication 6 ou 7, dans lequel le diamètre maximal de l'au moins un renflement est plus grand que le diamètre intérieur maximal de l'enfoncement coopérant.

9. Ensemble support de substrat de l'une quelconque des revendications 6 à 8, dans lequel, par rapport au plan du support de substrat, la pente de l'au moins un renflement est plus grande que la pente intérieure de l'enfoncement coopérant.

10. Ensemble support de substrat de l'une quelconque des revendications 3 à 5, dans lequel au moins une partie des dimensions intérieures de l'au moins un enfoncement est surdimensionnée par rapport à la partie correspondante des dimensions extérieures du renflement coopérant.

11. Ensemble support de substrat de la revendication 10, dans lequel la profondeur maximale de l'au moins un enfoncement est plus grande que la hauteur maximale du renflement coopérant.

12. Ensemble support de substrat de la revendication 10 ou 11, dans lequel le diamètre intérieur maximal de l'au moins un enfoncement est plus grand que le diamètre maximal du renflement coopérant.

13. Ensemble support de substrat de l'une quelconque des revendications 10 à 12, dans lequel, par rapport au plan du support de substrat, la pente de l'au moins un renflement est plus petite que la pente intérieure de l'enfoncement coopérant.

14. Support de substrat, faisant partie d'un ensemble support de substrat destiné à être utilisé dans un système pour la croissance de couches épitaxiales sur des substrats semi-conducteurs par dépôt chimique en phase vapeur, ledit support de substrat ayant une première surface, une partie de zone dudit premier côté de surface étant munie de poches en retrait pour loger - en cours d'utilisation - lesdits substrats semi-conducteurs, ainsi que des moyens de verrouillage tels que définis dans une ou plusieurs des revendications 1 à 13.

15. Segment de protection (20', 20") faisant partie d'un ensemble support de substrat destiné à être utilisé dans un système pour la croissance de couches épitaxiales sur des substrats semi-conducteurs par dépôt chimique en phase vapeur, ledit segment de protection étant configuré en tant qu'élément en forme de plaque, ainsi que des moyens de verrouillage tels que définis dans une ou plusieurs des revendications 1 à 13.
